**Europäisches Patentamt**

**European Patent Office**

**Office européen des brevets**

(19)

(11) Veröffentlichungsnummer: **0 041 263**
**B1**

(12) ## EUROPÄISCHE PATENTSCHRIFT

(45) Veröffentlichungstag der Patentschrift:
**23.01.85**

(51) Int. Cl.⁴: **H 01 L 21/324**

(21) Anmeldenummer: **81104181.3**

(22) Anmeldetag: **01.06.81**

(54) **Verfahren zur Stabilisierung der Stromverstärkung von NPN-Siliciumtransistoren.**

(30) Priorität: **04.06.80 DE 3021215**

(43) Veröffentlichungstag der Anmeldung:
**09.12.81 Patentblatt 81/49**

(45) Bekanntmachung des Hinweises auf die Patenterteilung:
**23.01.85 Patentblatt 85/4**

(84) Benannte Vertragsstaaten:
**DE FR GB IT**

(56) Entgegenhaltungen:
**DE - A - 2 021 924**
**DE - A - 2 755 418**
**US - A - 4 154 873**

**IEEE TRANSACTIONS ON ELECTRON DEVICES Band ED-18, Nr. 8, 1971 New York B.A. McDONALD "Degradation of hFE at Moderate Current Levels"**

(73) Patentinhaber: **Siemens Aktiengesellschaft, Berlin und München Wittelsbacherplatz 2, D-8000 München 2 (DE)**

(72) Erfinder: **Arlt, Manfred, Dipl.-Phys., Pentenriederstrasse 46, D-8033 Krailling (DE)**
Erfinder: **Dathe, Joachim, Dipl.-Phys., Schleissheimerstrasse 276, D-8000 München 40 (DE)**

**Beschreibung**

Die Erfindung betrifft ein Verfahren zur Stabilisierung der Stromverstärkung von NPN-Transistoren.

Der Abfall der Stromverstärkung B, d. h., des Verhältnisses von Kollektorstrom zu Basisstrom von Bipolartransistoren ist ein bekanntes Problem der Halbleitertechnologie. Aus IEEE Trans. Electron Devices, Vol. ED 18, No. 8, Aug. 1971, S. 570 bis 573, ist bekannt, daß ein Abfall der Stromverstärkung nicht nur durch bewegliche Ionen im Oxid oder Avalance-Belastung der Emitter-Basis-Diode, sondern auch durch Temperatur-Sperrbelastung, im folgenden HTRB-Belastung (High-Temperature-Reverse-Bias) genannt, verursacht werden kann. Die HTRB-Belastung hat bei einem erheblichen Prozentsatz aller NPN-Transistoren einen linearen, d. h., über einen größeren Kollektorstrombereich konstanten Abfall der Stromverstärkung zur Folge. Dieser Abfall der Stromverstärkung wird auch als B-Drift bezeichnet. Diese B-Drift ist durch Erwärmung bei Hochstromdurchbruchbelastung bzw. durch Temperung ohne angelegte Sperrspannung ausheilbar, d. h. die ursprüngliche Stromverstärkung vor HTRB wird wieder erhalten.

Flußbelastung der Emitter-Basis-Diode derart »gedrifteter« Transistoren führt zu einer weiteren Stromverstärkungsänderung, dem sogenannten B-Läufer-Effekt. Die durch diesen Effekt verursachte Stromverstärkungsänderung ist nichtlinear, die Transistoren zeigen ein instabiles Ausgangskennlinienfeld. Charakteristisch ist ein Stromverstärkungsabfall bei kleinen und ein Stromverstärkungsanstieg bei großen Kollektorströmen. Der B-Läufer-Effekt kann nicht nur durch HTRB-Belastung ausgelöst werden, sondern kann — wie eigene Untersuchungen gezeigt haben — z. B. auch ohne elektrische Belastung auftreten.

Aufgabe der vorliegenden Erfindung ist es, ein Verfahren anzugeben, durch das bereits bei der Transistorherstellung sichergestellt ist, daß beim späteren Betrieb der Transistoren keine Stromverstärkungsänderungen auftreten bzw. die auftretenden Stromverstärkungsänderungen erheblich vermindert werden.

Diese Aufgabe wird erfindungsgemäß dadurch gelöst, daß die Transistoren nach Abschluß der zur Herstellung notwendigen Hochtemperaturprozesse mindestens 30 Minuten bei einer Temperatur von 510 bis 590° C und mindestens 30 Minuten bei einer Temperatur von 380 bis 460° C getempert werden. Durch ein solches zweistufiges Temperverfahren wird ermöglicht, daß die getemperten Transistoren unter elektrischer Belastung eine stabile Stromverstärkung aufweisen.

Vorzugsweise wird zuerst der Temperprozeß mit der höheren Temperatur durchgeführt. Vorteilhafterweise wird der Temperprozeß mit der höheren Temperatur bei 530 bis 570° C und mindestens 60 Minuten lang durchgeführt, während der Temperprozeß mit der niedrigeren Temperatur vorteilhafterweise bei 420 bis 450° C und mindestens zwei Stunden lang durchgeführt wird.

Es liegt im Rahmen der Erfindung, daß der Temperprozeß mit der höheren Temperatur vor der Metallisierung der Transistoren und der Temperprozeß mit der niedrigeren Temperatur nach oder zugleich mit der Metallisierungssinterung der Transistoren durchgeführt wird und daß mindestens ein Temperprozeß in einer Stickstoff-Wasserstoff-Atmosphäre durchgeführt wird.

Die Stromverstärkung von NPN-Transistoren kann durch HTRB-Belastung bei 275° C beispielsweise nach zwei Stunden bereits auf 85% des ursprünglichen Wertes im Kollektorstrom-Bereich von 10 μA bis 50 mA gesunken sein. Diese B-Drift ist annähernd linear, d. h., unabhängig von der Größe des Kollektorstroms. Sie ist bei HTRB mit gesperrten Emitter-Basis- und Kollektor-Basis-Dioden am stärksten, während der Effekt bei gesperrter Emitter-Basis-Diode und kurzgeschlossener Kollektor-Basis-Diode geringer ist. Bei kurzgeschlossener Emitter-Basis-Diode und gesperrter Kollektor-Basis-Diode ist keine B-Drift vorhanden.

In der obengenannten Literaturstelle wird die B-Drift zwar als Volumeneffekt erklärt, die eigentliche Ursache im Siliciumvolumen konnte jedoch nicht ermittelt werden. Angaben, wie das Auftreten eines solchen Effektes zu verhindern sei, fehlen ebenfalls.

Eigene Untersuchungen legen die Vermutung nahe, daß die B-Drift durch Diffusion von elektrisch aktiven »Spezies« im elektrischen Feld der Raumladungszone hervorgerufen werden, wobei die Konzentration der »Spezies« durch den Scheiben- oder Epischichtherstellungsprozeß und/oder durch andere technologische Prozesse beeinflußt werden kann. Solche »Spezies« könnten beispielsweise eine Sauerstoff-Silicium, Stickstoff-Silicium, oder Kohlenstoff-Silicium-Verbindung (z. B. $SiO_2$, $SiO_4$, $SiN_2$, $SiC$) oder mehrere dieser Verbindungen sein. Die Notwendigkeit von zwei Temperschritten bei unterschiedlichen Temperaturen deutet auf das Vorhandensein von mindestens zwei unterschiedlichen »Spezies« hin. Durch diese Stabilisierungstemperungen wird die Konzentration oder die Beweglichkeit der »Spezies« offensichtlich so beeinflußt, daß die B-Drift verschwindet.

Bei PNP-Transistoren wurde bisher keine B-Drift beobachtet. Ursache könnte die umgekehrte Feldrichtung bei Sperrbelastung der Dioden sein, die die angenommene Feld-Diffusion verhindert, so daß ein entsprechender Effekt wohl vorhanden sein kann, aber elektrisch nicht wirksam wird.

Der B-Läufer-Effekt an nach HTRB-Belastung gedrifteten Transistoren zeigt ein instabiles Ausgangskennlinienfeld verursacht durch Flußbelastung der Emitter-Basis-Diode. Charakteristisch für diesen B-Läufer-Effekt ist der Stromverstärkungsabfall bei kleinen und Stromverstärkungsanstieg bei großen Kollektorströmen. Bei Fluß

belastung der Kollektor-Basis-Diode mit offener Emitter Basis-Diode wird quantitativ der gleiche B Läufer Effekt wie bei Belastung der Emitter-Basis-Diode mit offener Kollektor-Basis-Diode erhalten. Wird dagegen die nichtbelastete Diode kurzgeschlossen, tritt nur ein schwacher B-Läufer-Effekt auf. Aus Strompfadbetrachtungen kann daher geschlossen werden, daß der im Basisbereich lateral fließende Strom den B-Läufer-Effekt verursacht.

Nach Abschalten des Flußstromes tritt eine Relaxation ein, so daß nach endlicher Zeit die durch den B-Läufer-Effekt verursachte Basisstromänderung völlig ausgeheilt ist. Die Ausheilzeit ist stark temperaturabhängig, bei Zimmertemperatur werden beispielsweise bis zum völligen Verschwinden des Rekombinationsstromes bei einem Kollektorstrom von 10 µA ca. 5 Stunden benötigt.

Ebenso wie die B-Drift kann auch der B-Läufer-Effekt durch die erfindungsgemäße zweistufige Temperatur zum Verschwinden gebracht werden, da beide Effekte offensichtlich die gleiche thermische Aktivierungsenergie haben.

Vorteilhafterweise werden die Temperprozesse an den Siliciumscheiben vor der Zerteilung der Scheiben durchgeführt. Bei Durchführung nur eines Temperprozesses zeigt sich nur eine geringe Stabilisierung der Stromverstärkung. Die Dauer der Temperprozesse sollte 30 Minuten nicht unterschreiten, da sonst der erreichte Stabilisierungseffekt zu gering sein kann.

Durch zweistufige Stabilisierungstemperung von 75 Minuten 550° und 120 Minuten 420° konnte die B-Drift nach 1000 Std., 175°C, $U_{CB}$ = 30 V, $U_{EB}$ = 4 V nicht mehr nachgewiesen werden (Änderungsfaktor der Stromverstärkung B nach HTRB/BvorHTRB = 0,97 ... 1,03). Ohne Stabilisierungstemperung hatten Transistoren Änderungsfaktoren bei der gleichen Belastung von 0,5 ... 0,7.

Der B-Läufer-Effekt, der ohne Stabilisierungstemperung zu einem B-Änderungsfaktor bei $J_C$ = 10 µA von 0,5 führte, reduzierte sich durch obige Temperprozesse ebenfalls auf 0,97 ... 1,0.

Die Mindesttemperzeit wird durch die jeweilige Konzentration der elektrisch aktiven Spezies im Siliciumvolumen bestimmt, die obere Grenze der Temperzeit ist im wesentlichen nur durch wirtschaftliche Überlegungen limitiert. Während der Hochtemperatur-Temperprozeß in der Regel vor der Metallisierung der Bauelemente durchgeführt wird, kann der Temperprozeß mit der niedrigeren Temperatur nach oder auch zugleich mit der Metallisierungssinterung, z. B. einer Aluminium-Metallisierung durchgeführt werden. Somit ist es möglich, einen Verfahrensschritt zu sparen.

Prinzipiell ist der Oberflächenzustand der zu tempernden Scheiben, beispielsweise Metallisierung oder Passivierung, unkritisch, da es sich um reine Volumentempereffekte handelt. Dies gilt auch für die Atmosphäre, in der die Temperprozesse durchgeführt werden. Günstig kann es jedoch sein, eine Stickstoff-Wasserstoff-Atmosphäre, beispielsweise ein aus Stickstoff und 10% Wasserstoff bestehendes Formiergas zu verwenden, da dies für die Oberflächeneigenschaften der Transistoren vorteilhaft ist.

## Patentansprüche

1. Verfahren zur Stabilisierung der Stromverstärkung von NPN-Siliciumtransistoren, dadurch gekennzeichnet, daß die Transistoren nach Abschluß der zur Herstellung notwendigen Hochtemperaturprozesse mindestens 30 Minuten bei einer Temperatur von 510 bis 590°C und mindestens 30 Minuten bei einer Temperatur von 380° bis 460°C getempert werden.

2. Verfahren nach Anspruch 1, dadurch gekennzeichnet, daß zuerst der Temperprozeß mit der höheren Temperatur durchgeführt wird.

3. Verfahren nach Anspruch 1 oder 2, dadurch gekennzeichnet, daß der Temperprozeß mit der höheren Temperatur bei 530 bis 570°C durchgeführt wird.

4. Verfahren nach wenigstens einem der Ansprüche 1 bis 3, dadurch gekennzeichnet, daß der Temperprozeß mit der höheren Temperatur mindestens 60 Minuten lang durchgeführt wird.

5. Verfahren nach wenigstens einem der Ansprüche 1 bis 4, dadurch gekennzeichnet, daß der Temperprozeß mit der niedrigeren Temperatur bei 420 bis 450°C durchgeführt wird.

6. Verfahren nach wenigstens einem der Ansprüche 1 bis 5, dadurch gekennzeichnet, daß der Temperprozeß mit der niedrigeren Temperatur mindestens zwei Stunden lang durchgeführt wird.

7. Verfahren nach wenigstens einem der Ansprüche 1 bis 6, dadurch gekennzeichnet, daß der Temperprozeß mit der höheren Temperatur vor der Metallisierung der Transistoren und der Temperprozeß mit der niedrigeren Temperatur nach oder zugleich mit der Metallisierungssinterung der Transistoren durchgeführt wird.

8. Verfahren nach wenigstens einem der Ansprüche 1 bis 8, dadurch gekennzeichnet, daß mindestens ein Temperprozeß in einer Stickstoff-Wasserstoff-Atmosphäre durchgeführt wird.

## Claims

1. A process for stabilising the current gain of NPN silicon transistors, characterised in that after the completion of the high-temperature operations which are required for production, the transistors are annealed at a temperature of 510 to 590°C for at least 30 minutes, and at a temperature of 380° to 460°C for at least 30 minutes.

2. A process as claimed in claim 1, characterised in that the annealing operation at the higher temperature is carried out first.

3. A process as claimed in claim 1 or 2, characterised in that the annealing operation at the higher temperature is carried out at 530 to 570°C.

4. A process as claimed in at least one of claims 1 to 3, characterised in that the annealing operation at the higher temperature is carried out for at least 60 minutes.

5. A process as claimed in at least one of claims 1 to 4, characterised in that the annealing operation at the lower temperature is carried out at 420 to 450° C.

6. A process as claimed in at least one of claims 1 to 5, characterised in that the annealing operation at the lower temperature is carried out for at least two hours.

7. A process as claimed in at least one of claims 1 to 6, characterised in that the annealing operation at the higher temperature is carried out before the metallisation of the transistors and the annealing operation at the lower temperature is carried out after or simultaneously with the sintering of the metallisation of the transistors.

8. A process as claimed in at least one of claims 1 to 8, characterised in that at least one annealing operation is carried out in a nitrogen-hydrogen atmosphere.

**Revendications**

1. Procédé pour stabiliser le gain en courant de transistors NPN au silicium, caractérisé par le fait qu'à la fin des processus de traitement à haute température qui sont nécessaire pour la fabrication, on réalise un recuit des transistors pendant au moins 30 minutes à une température comprise entre 510 et 590° C et pendant au moins 30 minutes à une température comprise entre 380 et 460° C.

2. Procédé suivant la revendication 1, caractérisé par le fait qu'on met en oeuvre tout d'abord le processus de recuit effectué avec la température supérieure.

3. Procédé suivant la revendication 1 ou 2, caractérisé par le fait qu'on met en oeuvre le processus de recuit effectué avec la température supérieure, entre 530 et 570° C.

4. Procédé suivant au moins l'une des revendications 1 à 3, caractérisé par le fait que l'on met en oeuvre le processus de recuit effectué avec la température supérieure, pendant au moins une durée de 60 minutes.

5. Procédé suivant au moins l'une des revendications 1 à 4, caractérisé par le fait qu'on met en oeuvre le processus de recuit effectué avec la température inférieure, entre 420 et 450° C.

6. Procédé suivant au moins l'une des revendications 1 à 5, caractérisé par le fait qu'on met en oeuvre le processus de recuit effectué avec la température inférieure, pendant au moins une durée de 2 heures.

7. Procédé suivant au moins l'une des revendications 1 à 6, caractérisé par le fait que l'on met en oeuvre le processus de recuit effectué avec la température supérieure avant la métallisation des transistors et qu'on met en oeuvre le processus de recuit effectué avec la température inférieure après le frittage de métallisation des transistors ou en même temps que ce frittage.

8. Procédé suivant au moins l'une des revendications 1 à 8, caractérisé par le fait qu'on met en oeuvre au moins un processus de recuit dans une atmosphère d'azote et d'hydrogène.